Europäisches Patentamt

European Patent Office

Office européen des brevets

(19)

(11) Publication number: **0 068 636**
**A1**

## (12) EUROPEAN PATENT APPLICATION

(21) Application number: **82302700.8**

(22) Date of filing: **26.05.82**

(51) Int. Cl.³: **H 01 J 37/32, H 01 B 17/42**

(30) Priority: **18.06.81 GB 8118712**

(43) Date of publication of application: **05.01.83**
**Bulletin 83/1**

(84) Designated Contracting States: **AT CH DE FR GB IT LI
NL SE**

(71) Applicant: **CONSARC ENGINEERING LIMITED, 12 North
Road Bellshill, Lanarkshire Scotland (GB)**

(72) Inventor: **Dick, Thomas Rodgers, 36 Russel Street,
Hamilton Lanarkshire Scotland (GB)**
Inventor: **Irwin, Patrick, 2 Burns Gardens, Blantyre
Lanarkshire Scotland (GB)**

(74) Representative: **Ferguson, James MacKay et al,
Cruikshank & Fairweather 19 Royal Exchange Square,
Glasgow, G1 3AE (GB)**

(54) Insulator for glow discharge apparatus.

㊿ The invention relates to an insulator for use in a
glow discharge apparatus.

The insulator (6) is located between an anode (1, 4)
and a cathode (2). It is formed with an annular groove
(7 or 12) so located that at least one of its side faces
lies within the width of one of the dark spaces, prefer-
ably the Crookes dark space, present in a glow discharge occurring between the anode and the cathode.

In use the presence of the groove at the dark space
prevents the deposition of metal ions on the insulator
at the position of the dark space so that the insulator
maintains its insulating properties.

INSULATOR FOR GLOW

DISCHARGE APPARATUS

This invention relates to insulators for use in glow discharge apparatus. It has particular reference to insulators used in apparatus for the treatment of steel by the process known as plasma nitriding.

In most processes employing glow discharge apparatus one of the difficulties is in providing adequate insulation between the anode and the cathode between which the discharge takes place. This problem can usually be overcome by the provision of an insulator of sufficient surface length between the electrodes. Although some glow discharge still takes place over the surface of the insulator this is usually not serious enough to cause difficulties. In the process of plasma nitriding however an additional difficulty is that the glow discharge used in the process carries with it metal ions and the discharge across any insulator required to support the cathode within the anode, which in the plasma nitriding process is usually the chamber in which the process takes place, deposits metal particles on the insulator. This deposit soon forms an electrical path between the cathode and the anode sufficient to cause breakdown of the insulator.

It is an object of the present invention to provide an insulator which does not suffer from this trouble.

According to the invention an insulator for separating electrically an anode and a cathode is formed with at least one annular groove located between the ends of the insulator which are in contact with the anode and the cathode, the groove being so located that at least one side face defining the width of the groove, i.e. the dimension in the direction between the anode and the cathode, lies within the width of one of the dark spaces present in a glow discharge **0068636**
occuring between the anode and the cathode.

Preferably the dark space chosen for the location of the groove is the Crookes dark space.

The groove may be a rabbet formed in the end of the insulator adjacent the cathode, the face of the rabbet opposite the cathode being nearer the cathode than the boundary of the Crookes dark space nearer the anode.

Alternatively the groove may be formed as a channel in the insulator so located and of a width such that it is narrower than and lies between the boundaries of the Crookes dark space.

In a glow discharge there are other dark spaces and grooves may also be formed in the insulation coincident with these other dark spaces. The groove opposite the Crookes dark space is however the most effective because the Crookes dark space is normally the widest of the dark spaces present in such a glow discharge.

The insulator may be formed with additional grooves to increase the length of the insulating path between the anode and the cathode.

There are three parameters which affect the dimensions of the Crookes dark space. These are the materials of which the electrodes are made, the pressure prevailing around the insulator and the potential difference between the anode and the cathode. The effects of variations in these parameters on the positions of the various dark spaces are well known and the position and width of the groove opposite any chosen dark space is calculated with respect to the readily calculated or observed position of the dark space to ensure that the groove is located and dimensioned as defined above.

Two practical embodiments of the invention are illustrated in the accompanying drawing which illustrates a portion of the input conductor leading into a furnace in which plasma nitriding is to take place through the wall of the furnace chamber which functions as the anode, the conductor leading into the furnace conveying electric current to the cathode. In this construction a cylindrical insulator is located between the anode and the cathode and two different forms of groove are illustrated on opposite sides of the insulator .

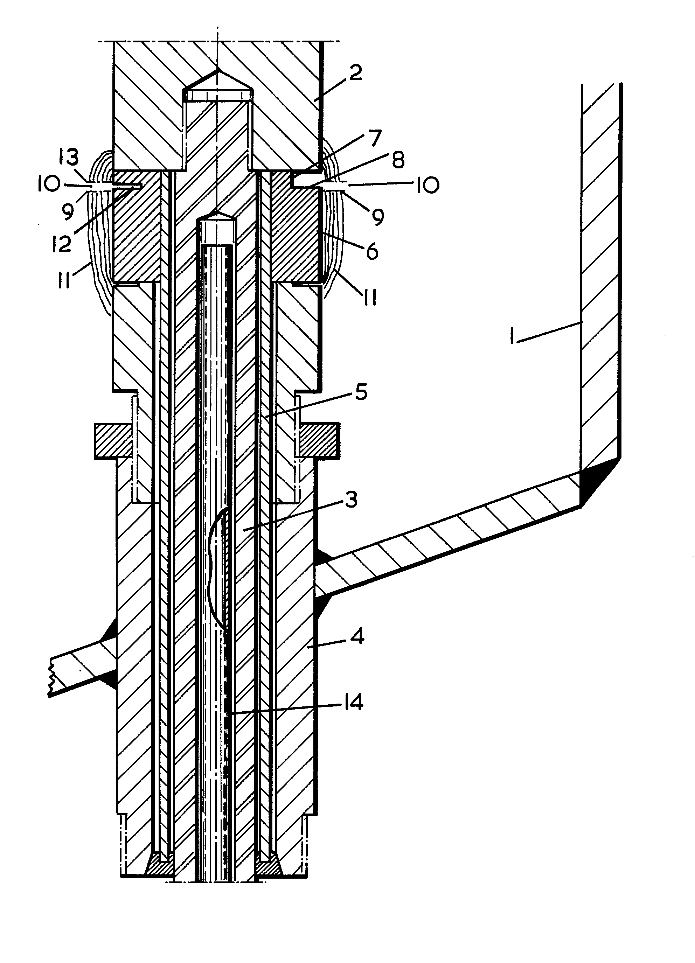

In the drawings 1 denotes the wall of the chamber in which the nitriding process takes place and constituting the anode, 2 denotes the cathode connected to a conductor 3 passing through the wall of the chamber 1 by way of a tubular support 4 passing through the wall of the chamber and electrically connected thereto so that the support 4 forms part of the anode. The conductor 3 is insulated from the support 4 by an insulating sleeve 5 and by a cylindrical insulator 6 located between the tubular support 4 and the cathode 2. The side of the drawing on the right of the centre line shows a construction in which a groove or rabbet 7 is formed in the end of the insulator 6 adjacent the cathode 2 (the Crookes dark space is always closer to the cathode) the face 8 of the rabbet 7 being nearer the cathode than the boundary 9 of the Crookes dark space 10 in the glow discharge 11 between the anode 1 and the cathode 2. The side of the drawing on the left of the centre line shows a construction in which a groove in the form of a channel 12 narrower than the width of the Crookes dark space 10 lies wholly between the boundaries 9 and 13 of the Crookes dark space 10. 14 denotes a tube for conducting cooling liquid into the conductor 3.

In operation, when a glow discharge occurs between the part of the anode constituted by the support 4 and the cathode 2, in the part of the glow discharge 11 other than the Crookes dark space 10 metal ions deposited on the insulator 6 soon build up a metal deposit there. However, in the Crookes dark space some deposit of metal still takes place even at a much reduced rate so that a plain insulator breaks down through time but the groove constituted by the rabbet 7 or the channel 12 is sufficient to prevent any formation of metal at the position of the Crookes dark space so that a current path is never formed across the insulator. It is not sufficient to provide annular grooves at other positions only along the insulator because the deposit rate is high enough to bridge a narrow groove or to fill up a wide groove although other grooves may be formed in the insulator for the purpose of lengthening the insulating surface. It has been found that by the method of the invention a plasma nitriding process can continue indefinately without break down of the insulator between the anode and the cathode. Actual installations according to the invention have been in continual operation for many months without breakdown whereas with previously known constructions breakdown of the insulator sometimes occurs during one nitriding treatment.

0068636

CLAIMS

1. An insulator (6) for separating electrically an anode (1, 4) and a cathode (2) is characterized by being formed with at least one annular groove (7 or 12) located between the ends of the insulator which are in contact with the anode and the cathode, the groove being so located that at least one side face (8) defining the width of the groove, i.e. the dimension in the direction between the anode and the cathode, lies within the width of one of the dark spaces (10) present in a glow discharge occurring between the anode and the cathode.

2. An insulator according to claim 1, characterized in that the groove is located to lie within the width of the Crookes dark space (10).

3. An insulator according to claim 2, characterized in that the groove is a rabbet (7) formed in the end of the insulator adjacent the cathode (2), the face (8) of the rabbet (7) opposite the cathode (2) being nearer the cathode than the boundary of the Crookes dark space (10) nearer the anode (4, 1).

4. An insulator according to claim 1, characterized in that the groove is formed as a channel (12) in the insulator so located and of a width such that it is narrower than and lies between the boundaries of the dark space (10).

5. An insulator (6) in combination with an anode (4) and a cathode (2) the insulator being located between the anode and the cathode characterized in that the insulator is formed with at least one annular groove (7 or 12) located between the ends of the insulator which are in contact with the anode and the cathode, the groove being so located that at least one side face (8) defining the width of the groove, i.e. the dimension in the direction between the anode and the cathode, lies within the width of one of the dark spaces (10) present in a glow discharge occurring between the anode and the cathode.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A | GB-A- 818 413 (BERGHAUS) <br> * Page 3, lines 3-120; page 4, lines 14-65; figures 3-5 * | 1,3-5 | H 01 J 37/32 <br> H 01 B 17/42 |
| A | US-A-2 762 945 (BERGHAUS) <br> * Column 4, lines 13-71; figures * | 1,3-5 | |

TECHNICAL FIELDS SEARCHED (Int. Cl. 3)

H 01 B 17/00
H 01 J 37/00
H 01 J 17/00

The present search report has been drawn up for all claims

| Place of search <br> THE HAGUE | Date of completion of the search <br> 15-10-1982 | Examiner <br> TIELEMANS H.L.A. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82